# EUROPEAN PATENT APPLICATION

(11) **EP 4 671 407 A1**
(43) Date of publication of application: **31.12.2025**
(21) Application number: 24205218.1
(22) Date of filing: 08.10.2024
(51) Int. Cl.: C23C 14/34, H01J 37/32, H01J 37/34, C23C 14/56

(54) **METHOD OF TREATING A SHUTTER OF A PVD APPARATUS**

(30) Priority: 27.06.2024 GB 202409318
(71) Applicant: SPTS Technologies Limited, NP18 2TA (GB)
(72) Inventor: HAYMORE, Scott, Newport, NP18 2TA (GB); WILBY, Tony, Newport, NP18 2TA (GB); JONES, Stephen, Newport, NP18 2TA (GB)
(74) Representative: Wynne-Jones IP Limited

(57) **Abstract**

According to the invention there is provided a method of treating a shutter of a PVD apparatus comprising the steps of:
providing a PVD apparatus comprising a chamber, a target, a substrate support positioned in the chamber and a shutter which is deployable within the chamber to divide the chamber into a first compartment in which the substrate support is positioned, and a second compartment in which the target is positioned;
providing a substrate having a pasting material deposited thereon, said substrate being positioned on the substrate support;
deploying the shutter within the chamber to divide the chamber into the first and second compartments, the shutter having an underside which, in its deployed position, faces the substrate, wherein at least one contaminant material is present on the underside; and
generating a plasma in the first compartment to sputter etch pasting material onto the underside of the shutter, thereby pasting the contaminant material to the underside of the shutter.

## Description

### Field of the Disclosure

This invention relates to a method of treating a shutter of a PVD apparatus, with particular reference to a method of pasting material onto the shutter, so as to paste contaminant material to the shutter. The invention relates also to an associated PVD apparatus comprising a shutter.

### Background of the Disclosure

It is known to lower the contact resistance of UBM/RDL (Under Bump Metallization / Re-Distribution Layers) structures present on a wafer substrate by reducing the amount of oxide present at the interface between an Al contact pad and a PVD Ti seed layer. To achieve this reduced oxide presence, the wafer is first degassed under vacuum to remove H₂O and other volatile contaminants that may oxidize the pad surface or interfere with the electrical properties of the subsequently deposited metal films. This is followed by a sputter etch to remove native oxide from the Al pad. The sputter etch process presents a problem as the passivation material typically used for UBM/RDL processes is an organic polymer such as PI (polyimide) or PBO (polybenzoxazole). When this material undergoes the sputter etch process it breaks down into smaller organic components which can then re-oxidize the sputter cleaned Al surface. The regrowth in the oxide layer leads to an increase in contact resistance. The amount of oxide regrowth is dependent on several factors, one of which is the time delay between the etch process ending and the PVD process starting. Usually, the wafer is etched in a dedicated sputter etch module, then transferred through a vacuum dealer to a dedicated deposition module, such as a PVD apparatus. The time delay in transferring the wafer from the sputter etch module to the PVD apparatus can give rise to undesirable levels of oxide regrowth on the wafer.

The Applicant has previously described, in European patent application EP 4207 245 A1, an invention which addresses this problem. The Applicant's inventive process utilizes a shutter which is deployed within the chamber of the PVD apparatus. A second etch is performed within the chamber with the shutter deployed to remove the regrown oxide. As this process is run in-situ, the transfer time between the end of the etch and the start of the deposition is greatly reduced, thus greatly reducing the amount of oxide regrowth and thereby reducing the contact resistance.

However, the present inventors have realized that organic material progressively builds up on chamber architecture such as shielding as more wafers are etched. This presents a problem as this material can delaminate, which causes particle performance in the chamber to degrade and provides a source of contamination which affects the resistivity of the PVD deposited film. The PVD deposition process can itself help in controlling particles and contaminants which might otherwise delaminate by pasting them to the walls of the chamber and also to architecture such as shielding under a layer of the PVD deposited material. However, the present inventors have realized that there are portions of the chamber that are within line of sight of the etch process but not of the deposition process, notably the underside of the shutter. Particles and contaminants located here are not pasted in place by the PVD deposition process and thus become a potential source of contamination within the chamber.

### Statement of Invention

The present invention, in at least some of its embodiments, addresses the above-described problems. In particular, the present invention, in at least some of its embodiments, provides a practical solution to the problem of contaminant material build-up on the underside of a shutter located in a PVD apparatus.

According to a first aspect of the invention there is provided a method of treating a shutter of a PVD apparatus comprising the steps of:
providing a PVD apparatus comprising a chamber, a target, a substrate support positioned in the chamber and a shutter which is deployable within the chamber to divide the chamber into a first compartment in which the substrate support is positioned, and a second compartment in which the target is positioned;
providing a substrate comprising a pasting material, said substrate being positioned on the substrate support;
deploying the shutter within the chamber to divide the chamber into the first and second compartments, the shutter having an underside which, in its deployed position, faces the substrate, wherein at least one contaminant material is present on the underside; and
generating a plasma in the first compartment to sputter etch pasting material onto the underside of the shutter, thereby pasting the contaminant material to the underside of the shutter.

The invention provides a practical solution which can be readily integrated into a variety of PVD deposition processes.

The substrate comprising a pasting material can be a base substrate having the pasting material deposited thereon. The base substrate having the pasting material deposited thereon can be provided by positioning the base substrate on the substrate support and using the PVD apparatus to deposit the pasting material onto the base substrate by PVD. Alternatively, the base substrate having the pasting material formed thereon can be provided by depositing the pasting material onto the base substrate outside of the chamber, wherein subsequently the base substrate is positioned on the substrate support.

Alternatively, the substrate can consist or consist essentially of the pasting material. For example, the substrate can be provided as a body formed from the pasting material, such as a disk formed from the pasting material.

The pasting material can be titanium. In this instance, the target can be formed from titanium. It is convenient if the main PVD deposition process is titanium deposition and the pasting material is also titanium. This enables a substrate having the pasting material deposited thereon to be provided by positioning the base substrate on the substrate support and using the PVD apparatus to deposit titanium onto the base substrate by PVD. This is true of any other instance in which the main PVD deposition process deposits the same material as the pasting material.

Alternatively, the pasting material can be barium, cerium or aluminium.

The PVD apparatus can be configured to separately perform a PVD deposition step. The substrate support can be at a first position during the step of sputter etch pasting material onto the underside of the shutter and at a second position during the step of performing the PVD deposition step, wherein the second position is closer to the target than the first position. It has been found that adopting these configurations enhances the effectiveness of both steps.

The step of sputter etch pasting material onto the underside of the shutter can be performed with a separation between the substrate and the underside of the shutter in the range 25 to 75 mm.

The step of generating a plasma in the first compartment can comprise generating the plasma by applying an RF electrical signal to the substrate support. The shutter can be grounded while the plasma is generated by applying the RF electrical signal to the substrate support. Typically, the shutter is permanently grounded.

The contaminant material can be an organic material. The organic material can be formed following PVD processing of a substrate that comprises an organic polymer. The organic polymer can be PI or PBO.

The organic material can be formed following PVD processing of a substrate that comprises an organic dielectric material.

The method can further comprise the previous steps of:
positioning a workpiece semiconductor substrate with an electrically conductive feature formed thereon on the substrate support;
deploying the shutter within the chamber to divide the chamber into the first and second compartments; and
simultaneously maintaining a first plasma in the first compartment to remove material from the electrically conductive feature and a second plasma in the second compartment to clean the target, in which the removal of material from the electrically conductive feature gives rise to the contaminant material on the underside of the shutter.

The Applicant's European patent application EP 4207 245 A1 (the contents of which are herein incorporated by reference) describes methods in accordance with these previous steps. However, the skilled reader will appreciate that the present invention can be used in conjunction with a wide range of PVD deposition applications, which may or may not involve PVD deposition on to a substrate with an electrically conductive feature formed thereon.

The substrate having the pasting material deposited thereon can be a semiconductor substrate. The semiconductor substrate can be a semiconductor wafer.

According to a second aspect of the invention there is provided a PVD apparatus comprising:
a chamber comprising a substrate support and a target;
a shutter which can be deployed within the chamber when, in use, a substrate comprising a pasting material is positioned on the substrate support, wherein the shutter is deployed to divide the chamber into a first compartment in which the substrate support is positioned, and a second compartment in which the target is positioned, and the shutter has an underside which, in its deployed position, faces the substrate support;
a plasma generation device for generating a plasma in the first compartment to sputter etch pasting material from the substrate onto the underside of the shutter, thereby pasting any contaminant material present on the underside of the shutter; and
a controller configured to control the apparatus in use (i) to deploy the shutter and (ii) to generate the plasma in the first compartment to sputter etch the pasting material.

The PVD apparatus can be configured to separately perform a PVD deposition step. The controller and the substrate support can be configured so that the substrate support is at a first position during the step of sputter etch pasting material onto the underside of the shutter and at a second position during the step of performing the PVD deposition step, wherein the second position is closer to the target than the first position.

The controller can be configured to control a position of the substrate support so that there is a separation between the substrate and the underside of the shutter in the range 25 to 75 mm, preferably in the range 30 to 70 mm, whilst the plasma in the first compartment is generated to sputter etch the pasting material.

The PVD apparatus can further comprise an anode structure that substantially or completely surrounds the target, wherein a plasma can be generated between the target and the anode structure.

In general, a magnetron assembly is disposed behind the target, as is well known to the skilled reader.

For the avoidance of doubt, whenever reference is made herein to 'comprising' or 'including' and like terms, the invention is also understood to include more limiting terms such as 'consisting' and `consisting essentially'.

Whilst the invention has been described above, it extends to any inventive combination of the features set out above, or in the following description, drawings or claims. Any features disclosed in relation to the first aspect of the invention may be combined with any features disclosed in relation to the second aspect of the invention and *vice versa* as appropriate.

### Description of the Drawings

Embodiments of the invention will now be described, by way of example only, with reference to the accompanying drawings, in which:
Figure 1 is a cross-sectional semi-schematic view of a PVD apparatus of the invention during PVD deposition with the shutter in a retracted position; and
Figure 2 is a cross-sectional schematic view of a PVD apparatus of the invention during a shutter treatment step with the shutter in a deployed position.

### Detailed Description of the Disclosure

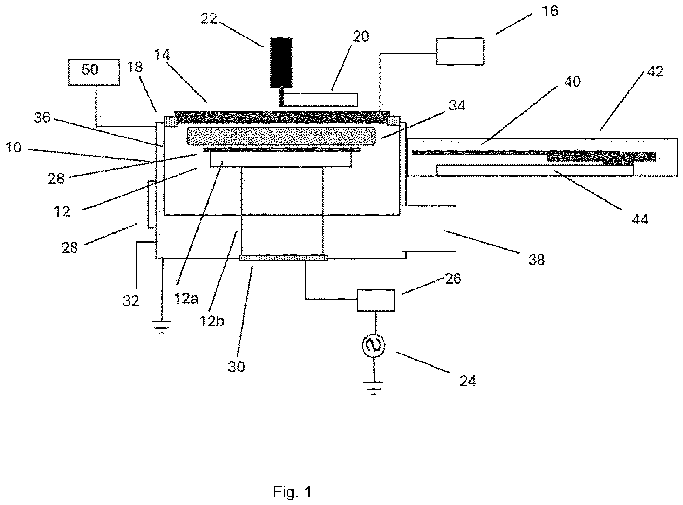

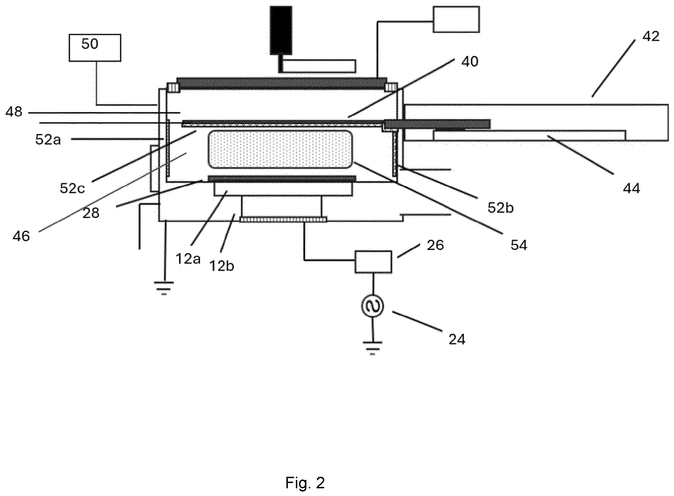

Figures 1 and 2 show a PVD apparatus of the invention. The apparatus is capable of operating in a deposition mode (shown in Figure 1) and also in a cleaning mode (shown in Figure 2) to remove material from an electrically conductive feature formed on a semiconductor substrate 28. The apparatus comprises a chamber 10 comprising a substrate support 12, such as a platen, and a target 14. A power supply 16 is used to supply power to the target 14 to generate and maintain a plasma for PVD deposition as is well understood by the skilled reader. The power supply 16 can be of any suitable type, such as DC, pulsed DC or RF power supply. The target 14 is electrically isolated from the grounded chamber 10 by a dielectric break 18. A rotating magnetron assembly 20 is swept around the target 14 by motor 22 to trap electrons in the vicinity of the target to improve deposition properties. The substrate support 12 is RF driven by a RF power supply 24 operating at a suitable frequency (typically 13.56MHz) through a matching network 26 to provide a DC bias Vdc to the semiconductor substrate 28 positioned on the substrate support 12. The substrate support 12 comprises a platen 12a and a pedestal 12b which is typically constructed from aluminium or stainless steel and is electrically isolated from the metallic chamber 10 by a ceramic break 30. Temperature control of the substrate support is achieved by conventional means such as resistive heating and cooling channels with temperature sensors (not shown).

During a PVD deposition cycle the apparatus is configured as shown in Figure 1. A suitable process gas such as Ar or Ar and N₂ is introduced into the chamber 10 through an inlet 32. Power is applied to the target 14 and a plasma 34 is formed in the chamber 10 in close proximity to the target 14. Positive ions such as Ar+ are directed to the target 14 and sputter target material into the chamber 10 towards the wafer 28. The walls of the chamber are protected by chamber shielding 36 which typically is of metal construction with a textured surface to help adhesion of the sputtered film. The chamber 10 is pumped by a suitable pumping system, typically utilizing cryopumps, through an opening 38. The substrate support 12 is in a raised position to maintain a desired gap, typically about 50-70mm, between the target and the semiconductor substrate.

The apparatus further comprises a shutter 40. During PVD deposition, the shutter 40 is stored in a storage position (shown in Figure 1) in an enclosure 42 which is coupled to the chamber 10. The shutter 40 can be deployed within the chamber 10 by way of being directly driven in a horizontal direction by a suitable mechanism 44. The deployed position of the shutter is shown in Figure 2. The shutter 40 is electrically grounded when deployed. The chamber shielding 36 and shutter 40 are designed specifically for long MTBC (mean time between cleans), by utilizing arc spray coating on all surfaces (top and underside). This provides good adhesion for sputtered species. A suitable choice of material for the shutter is Al which also provides good CTE (coefficient of thermal expansion) properties and a low likelihood of warpage, which ensures process repeatability. Alternatively, the shutter may be made of a material such as titanium. The thickness of the shutter can be in the range 10-15mm. The apparatus further comprises a controller 50 which controls the operation of the device.

Figure 2 shows a configuration in which the shutter 40 is deployed to divide the chamber into a first, lower, compartment 46 in which the substrate support 12 is positioned, and a second, upper, compartment 48 in which the target 14 is positioned. For presentational simplicity, not all of the reference numerals provided in Figure 1 are reproduced in Figure 2. However, it will be understood that Figure 2 shows the apparatus of Figure 1 in a different configuration. All of the elements shown of the apparatus shown in Figure 1 are present in Figure 2. As explained in EP 4207 245 A1, the shutter 40 is deployed after a semiconductor substrate 28 having an electrically conductive feature formed thereon is positioned on the substrate support 12. A pre-clean is performed in which optionally the RF power supply 24 supplies an RF power to the substrate support 12 to generate and maintain a first plasma 54 in the first compartment 46 to remove material from the electrically conductive feature. Optionally, the power supply 16 is used to power the target 14 to generate and maintain a second plasma (not shown) in the second compartment 48 to clean the target 14 as taught in EP 4207 245 A1. The power supply is also used to generate and maintain a plasma during PVD deposition. The controller 50 is configured to control the apparatus in use (i) to deploy the shutter and (ii) to simultaneously maintain the first plasma in the first compartment and the second plasma in the second compartment. In a representative process, a process gas such as Ar is introduced into the chamber and Ar+ ions produced by the first plasma are attracted to the semiconductor substrate 28 on the RF driven substrate support 12 due to the -ve Vdc. As a result, material is sputtered from the surface of the semiconductor substrate 28. Oxidized metal such as Al₂O₃ from Al bond pads is removed to produce native Al while organic dielectric material is also removed. Material removed from the surface of the semiconductor substrate 28 is captured on exposed surfaces in the regions 52a, 52b and 52c including the underside of the shutter as represented in 52c. It is noted that the substrate support 12 is lowered from the position assumed in Figure 1 by lowering the pedestal 12b to enable the deployment of the shutter 40. The lowering and raising of the pedestal 12b can be achieved by pneumatic or electrical actuation with a stainless steel bellows assembly.

At appropriate times, contaminant material is pasted to the chamber, chamber architecture and the shutter. Methods for achieving this will now be described. If the PVD apparatus is in the configuration shown in Figure 2, then the controller 50 causes the PVD apparatus to assume the configuration shown in Figure 1. Once the shutter 40 is retracted back into the enclosure 42, deposition from the target 14 can be used to paste contaminant material in the regions 52a and 52b. During this process, the surface of the substrate support 12 is covered, either by a wafer being processed or by an element such as a cover, conditioning wafer or a plate. However, it will be appreciated that contaminant material 52c on the underside of the shutter 40 is not accessible to this form of pasting.

In accordance with the invention, a pasting step is carried out on the underside of the shutter. In one non-limiting approach, a Ti film is PVD deposited first onto an upper surface of a wafer using the arrangement shown in Figure 1. A relatively thin Ti film of, for example, around 1000nm thickness is sufficient in many instances. This could be carried out in the same PVD module that performs the subsequent pasting step if the main process deposits Ti films. In this instance, a Ti film can be deposited onto the wafer at the same time as Ti is deposited from the target 14 to paste contaminant material in the regions 52a and 52b Alternatively, the Ti deposition step onto a wafer could be carried out in different chamber. Typical operating parameters for the Ti deposition step are shown in Table 1.

**Table 1.**

| Parameter | Typical range |
|---|---|
| Pressure (mTorr) | 2-4 |
| Target Power (kWatt) | 2-8 |
| Ar flow (sccm) | 50-200 |
| Target-wafer separation (mm) | 50-70 |

This is followed by a further pasting step in which contaminant material is pasted onto the underside of the shutter. The substrate support and newly Ti deposited wafer are lowered away from the target, the shutter is deployed in the chamber and an etch process is run on the Ti deposited wafer using the configuration shown in Figure 2. This process sputters Ti from the wafer, pasting the chamber walls and underside of the shutter. Typical operating parameters for the pasting step are shown in Table 2. In this way, etch rates of about 6.7nm/min are readily achieved. Build up of contaminant material below the plane in which PVD deposition onto the wafer takes place is minimized by having the shutter located slightly below this plane. In a non-limiting example the deployed shutter is located at around 90mm from the surface of the target surface. If a 300mm diameter wafer is used then a shutter diameter of about 420mm is appropriate to leave a gap of about 8mm with the surrounding shielding. The substrate support 12 is lowered so that there is a gap of about 30-70mm between the shutter and the wafer.

**Table 2.**

| Parameter | Typical range |
|---|---|
| Pressure (mTorr) | 2-5 |
| Ar flow (sccm) | 100-200 |
| RF power (Watts) | 400-600 |

The frequency and extent of the in-situ etch process depends on the type and amount of material being etched. This is readily adjusted according to the precise application. With regular pasting of the shutter, it is possible to control particle levels, maintain vacuum performance and therefore keep contact resistance low and repeatable through an entire chamber performance management cycle. It is possible also to extend the lifetime of the chamber and chamber architecture.

It will be apparent that the invention can be implemented in various ways. For example, other pasting materials than titanium might be used, such as barium, cerium or aluminium. It is advantageous if the material used as the pasting material also possesses good getter properties. However, this is not an essential quality. Neither is the invention limited to the processing of UBM/RDL structures. The skilled reader will understand that the invention can be applied to a wide range of substrates, deposited films and end applications.

## Claims

1. A method of treating a shutter of a PVD apparatus comprising the steps of:
providing a PVD apparatus comprising a chamber, a target, a substrate support positioned in the chamber and a shutter which is deployable within the chamber to divide the chamber into a first compartment in which the substrate support is positioned, and a second compartment in which the target is positioned;
providing a substrate comprising a pasting material, said substrate being positioned on the substrate support;
deploying the shutter within the chamber to divide the chamber into the first and second compartments, the shutter having an underside which, in its deployed position, faces the substrate, wherein at least one contaminant material is present on the underside; and
generating a plasma in the first compartment to sputter etch pasting material onto the underside of the shutter, thereby pasting the contaminant material to the underside of the shutter.

2. A method according to claim 1, in which the substrate comprising a pasting material is a base substrate having the pasting material deposited thereon.

3. A method according to claim 2, in which the base substrate having the pasting material deposited thereon is provided by positioning the base substrate on the substrate support and using the PVD apparatus to deposit the pasting material onto the base substrate by PVD.

4. A method according to claim 2, in which the base substrate having the pasting material formed thereon is provided by depositing the pasting material onto the base substrate outside of the chamber, wherein subsequently the base substrate is positioned on the substrate support.

5. A method according to claim 1, in which the substrate consists or consists essentially of the pasting material.

6. A method according to any one of claims 1 to 5, in which the pasting material is titanium.

7. A method according to claim 6 when dependent on claim 3, in which the target is formed from titanium.

8. A method according to any one of claims 1 to 5, in which the pasting material is barium, cerium or aluminium.

9. A method according to any previous claim, in which the PVD apparatus is configured to separately perform a PVD deposition step; and the substrate support is at a first position during the step of sputter etch pasting material onto the underside of the shutter and at a second position during the step of performing the PVD deposition step, wherein the second position is closer to the target than the first position.

10. A method according to any previous claim, in which the step of sputter etch pasting material onto the underside of the shutter is performed with a separation between the substrate and the underside of the shutter in the range 25 to 75 mm.

11. A method according to any previous claim, in which the step of generating a plasma in the first compartment comprises generating the plasma by applying an RF electrical signal to the substrate support; and, optionally, the shutter is grounded while the plasma is generated by applying the RF electrical signal to the substrate support.

12. A method according to any previous claim, in which the contaminant material is an organic material.

13. A method according to any previous claim further comprising the previous steps of:
positioning a workpiece semiconductor substrate with an electrically conductive feature formed thereon on the substrate support;
deploying the shutter within the chamber to divide the chamber into the first and second compartments; and
simultaneously maintaining a first plasma in the first compartment to remove material from the electrically conductive feature and a second plasma in the second compartment to clean the target, in which the removal of material from the electrically conductive feature gives rise to the contaminant material on the underside of the shutter.

14. A PVD apparatus comprising:
a chamber comprising a substrate support and a target;
a shutter which can be deployed within the chamber when, in use, a substrate having a pasting material deposited thereon is positioned on the substrate support, wherein the shutter is deployed to divide the chamber into a first compartment in which the substrate support is positioned, and a second compartment in which the target is positioned, and the shutter has an underside which, in its deployed position, faces the substrate support;
a plasma generation device for generating a plasma in the first compartment to sputter etch pasting material from the substrate onto the underside of the shutter, thereby pasting any contaminant material present on the underside of the shutter; and
a controller configured to control the apparatus in use (i) to deploy the shutter and (ii) to generate the plasma in the first compartment to sputter etch the pasting material.

15. A PVD apparatus according to claim 14 in which: the PVD apparatus is configured to separately perform a PVD deposition step; and the controller and the substrate support are configured so that the substrate support is at a first position during the step of sputter etch pasting material onto the underside of the shutter and at a second position during the step of performing the PVD deposition step, wherein the second position is closer to the target than the first position; and/or the controller is configured to control a position of the substrate support so that there is a separation between the substrate and the underside of the shutter in the range 25 to 75 mm whilst the plasma in the first compartment is generated to sputter etch the pasting material.
